# EUROPÄISCHE PATENTANMELDUNG

(11) **EP 0 834 926 A2**
(43) Veröffentlichungstag der Anmeldung: **08.04.1998**
(21) Anmeldenummer: 97114661.8
(22) Anmeldetag: 25.08.1997
(51) Int. Cl.: H01L 29/08, H01L 29/78, H01L 29/423

(54) **Durch Feldeffekt steuerbares Halbleiterbauelement**

(30) Priorität: 19.09.1996 DE 19638437
(71) Anmelder: SIEMENS AKTIENGESELLSCHAFT, 80333 München (DE)
(72) Erfinder: Tihanyi, Jenö, Dr.-Ing., 85551 Kirchheim (DE)

(57) **Zusammenfassung**

Durch Feldeffekt steuerbares Halbleiterbauelement bestehend aus einem Halbleiterkörper (1) mit
- mindestens einer Drainzone (2) vom ersten Leitungstyp,
- mindestens einer Sourcezone (3) vom ersten Leitungstyp,
- mindestens einer Gate-Elektrode (4), wobei diese gegenüber dem gesamten Halbleiterkörper (1)durch ein Gateoxid (8) isoliert ist,
wobei Zwischenzellenzonen (6) vorgesehen sind, die folgende Merkmale aufweisen:
- die Zwischenzellenzonen (6) beabstanden jeweils benachbarte Drainzonen (2) und Sourcezonen (3),
- die Zwischenzellenzone (6) enthalten die Gate-Elektroden (4) und das Gateoxid (8),
- die Zwischenzellenzonen (6) haben die Form von vertikalen Gräben, die sich von der Oberfläche der Scheibenvorderseite (11) vertikal über die Drain- und Sourcezonen (2, 3) hinaus in den Bulkbereich (5) des Halbleiterkörpers (1) erstrecken.

## Beschreibung

Die Erfindung betrifft ein durch Feldeffekt steuerbares Halbleiterbauelement bestehend aus einem Halbleiterkörper mit mindestens einer Drainzone vom ersten Leitungstyp, mit mindestens einer Sourcezone vom ersten Leitungstyp, mit mindestens einer Gate-Elektrode, wobei diese gegenüber dem gesamten Halbleiterkörper isoliert ist, sowie ein Verfahren zu dessen Herstellung.

Derartige durch Feldeffekt steuerbare Halbleiterbauelemente sind zum Beispiel MOS-Feldeffekttransistoren (MOSFETs). Diese MOSFETs sind seit langem bekannt und zum Beispiel im Siemens-Datenbuch 1993/94 SIPMOS-Halbleiter, Leistungstransistoren und Dioden, Seiten 29ff beschrieben. Figur 4 auf Seite 30 dieses Datenbuchs zeigt den prinzipiellen Aufbau eines derartigen Leistungstransistors. Der dort gezeigte Transistor stellt einen vertikalen n-Kanal-SIPMOS-Transistor dar. Bei einem derartigen Transistor dient das n⁺-Substrat als Träger mit der darunterliegenden Drainmetallisierung. Über dem n⁺-Substrat schließt sich eine n⁻-Epitaxieschicht an, die je nach Sperrspannung verschieden dick und entsprechend dotiert ist. Das darüberliegende Gate aus n⁺-Polysilizium ist in isolierendes Siliziumdioxid eingebettet und dient als Implantationsmaske für die p-Wanne und für die n⁺-Sourcezone. Die Sourcemetallisierung überdeckt die gesamte Struktur und schaltet die einzelnen Transistorzellen des Chips parallel. Weitere Einzelheiten dieses vertikal aufgebauten Leistungstransistors sind den Seiten 30ff des obigen Datenbuchs zu entnehmen.

Nachteil einer derartigen Anordnung ist, daß der Durchlaßwiderstand Rₒₙ der Drain-Source-Laststrecke mit zunehmender Spannungsfestigkeit des Halbleiterbauelementes zunimmt, da die Dicke der Epitaxieschicht zunehmen muß. Bei 50 V liegt der flächenbezogene Durchlaßwiderstand Rₒₙ bei ungefähr 0,20 Ω mm² und steigt bei einer Sperrspannung von 1000 V beispielsweise auf einen Wert von ca. 10 Ω mm² an.

Aus DE 27 06 623 ist ein laterales Leistungs-Halbleiterbauelement bekannt, bei dem durch stufenweise bzw. kontinuierliche Zunahme des Abstands zwischen Gate-Elektrode und Drainbereich eine höhere Durchbruchsspannung und ein niedrigerer Durchlaßwiderstand erzielt wird. Nachteil solcher lateraler Leistungs-Halbleiterbauelemente ist der verhältnismäßig große Platzbedarf, wodurch sich vergleichsweise wenig Leistungs-MOSFETs auf einem Chip integrieren lassen. Damit ist auch die steuerbare Leistung bei Parallelschaltung mehrerer Leistungs-MOSFETs geringer.

Aufgabe der vorliegenden Erfindung ist es, ein durch Feldeffekt steuerbares Halbleiterbauelement anzugeben, welches die aufgezeigten Nachteile nicht aufweist.

Diese Aufgabe wird durch den kennzeichnenden Teil des Anspruchs 1 gelöst. Es ist hier ein durch Feldeffekt steuerbares Halbleiterbauelement angegeben, welches Zwischenzellenzonen mit den folgenden Merkmalen aufweist:
- die Zwischenzellenzonen beabstanden jeweils benachbarte Drainzonen und Sourcezonen,
- jede Zwischenzellenzone enthält jeweils eine Gate-Elektrode, die im Gateoxid eingebettet sind,
- die Zwischenzellenzonen haben die Form von vertikalen Gräben, die sich von der Scheibenvorderseite vertikal über die Drain- und Sourcezonen hinaus in den Bulkbereich des Halbleiterkörpers erstrecken.

Durch das Einbringen vertikaler Gräben, in denen sich die Gate-Elektroden befinden, kann insbesondere bei lateralen MOSFETs Chipfläche gespart werden. Ein weiterer Vorteil ergibt sich durch das Verlagern der Gate-Elektroden in den Halbleiterkörper hinein. Dadurch erhalten die erfindungsgemäßen Leistungs-MOSFETs bessere Sperreigenschaften bei gleichzeitig niedrigerem Einschaltwiderstand Rₒₙ.

Die Patentansprüche 2 bis 5 sind auf eine bevorzugte Ausgestaltung der Gate-Elektroden und Gateoxidbereiche gerichtet. Die Form bzw. die Lage der Gate-Elektroden in den Gräben kann je nach Anforderung gewählt werden und bestimmt im wesentlichen die Durchbruchsspannung bzw. den Einschaltwiderstand der Leistungs-MOSFETs. Als Gatematerial wird bevorzugt hochdotiertes Polysilizium verwendet, da es prozeßtechnisch einfach handhabbar ist und eine gute Leitfähigkeit aufweist.

In einer Weiterbildung gemäß Patentansprüche 6 und 7 sind unter den Zwischenzellenzonen ionenimplantierte hochdotierte Bereiche vorgesehen. Durch diese sogenannte Kanalimplantation kann die Einsatzspannung des Kanals der MOSFETs gezielt eingestellt werden.

Die Patentansprüche 8 und 9 sind auf die Kontaktregionen in den Source- bzw. Drainzonen gerichtet. Diese Kontaktregionen für die Drain- und Sourceanschlüsse müssen eine ausreichend hohe Dotierungskonzentration aufweisen, damit ein ohmscher Kontakt zwischen Halbleiter und Metallisierung gewährleistet ist. Vorteilhaft für die Spannungsfestigkeit ist es, wenn die Kontaktregionen nicht bis zum Gateoxid in den Zwischenzellenzonen reichen. Durch Ionenimplantation läßt sich eine exakt bestimmbare Dotierungsdosis in den Kontaktregionen einbringen und damit die gewünschte Dotierungskonzentration in den gewünschten Bereichen einstellen.

Der Patentanspruch 10 ist auf ein bevorzugtes Herstellungsverfahren des erfindungsgemäßen Halbleiterbauelements gerichtet.

Die Erfindung wird nachfolgend anhand der in den Figuren der Zeichnung dargestellten Ausführungsbeispiele näher erläutert. Es zeigt:
- Figur 1: einen Teilschnitt durch erfindungsgemäße laterale MOSFETs, wobei sich die Gate-Elektroden in Gräben befinden;
- Figur 2: verschiedene Ausführungsformen der Gate-Elektrode.

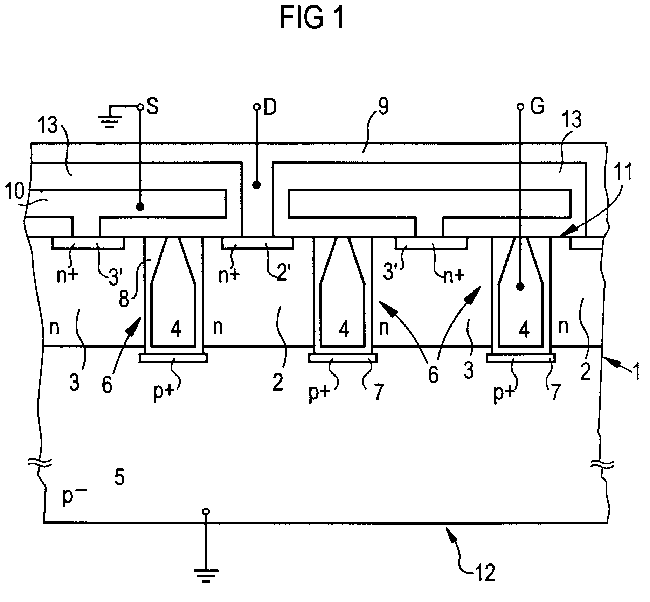

Figur 1 zeigt eine bevorzugte Ausführungsform der erfindungsgemäßen lateralen MOSFET-Anordnung. Ein Halbleiterkörper 1, beispielsweise eine Siliziumscheibe, ist wahlweise n- oder p-dotiert. Der Leitungstyp und die Dotierungskonzentration wird je nach Anforderung gewählt. Der unbehandelte Halbleiterkörper 1 wird im folgenden als Bulkbereich 5 bezeichnet. Im vorliegenden Beispiel ist der Bulkbereich 5 p⁻-dotiert. Der Bulkbereich 5 ist an der Scheibenrückseite 12 auf Massepotential geschaltet. Die Scheibenrückseite 12 bildet damit den Substratanschluß des MOSFETs. Vorteilhafterweise ist zwischen Rückseitenkontakt und Bulkbereich 5 zur besseren Kontaktierung noch eine p⁺-dotierte Schicht aufgebracht.

Über dem Bulkbereich 5 befinden sich die Drainzonen 2 und Sourcezonen 3, die beispielsweise epitaktisch aufgebracht sind. Die Drainzonen 2 und die Sourcezonen 3 weisen dieselbe Dotierung, im vorliegenden Fall n-Dotierung, auf. Die Dotierungskonzentrationen in den Drainzonen 2 und den Sourcezonen 3 sollten, müssen aber nicht notwendigerweise, gleich sein.

Die Drainzonen 2 und die Sourcezonen 3 sind voneinander beabstandet, wobei jeweils der Abstand zwischen einer Drainzone 2 und einer Sourcezone 3 eine Zwischenzellenzone 6 definiert. Die Zwischenzellenzonen 6 haben die Form von vertikal in den Halbleiterkörper 1 hineinreichende Gräben. Diese Gräben erstrecken sich von der Scheibenvorderseite 11 des Halbleiterkörpers 1 vertikal über die Drainzone 2 und die Sourcezone 3 hinaus in den Bulkbereich 5 des Halbleiterkörpers 1. Von besonderem Vorteil kann es sein, den Scheitelstrich beziehungsweise Umkehrpunkt der Gräben der Zwischenzellenzonen 6 eher U-förmig auszubilden.

Die Zwischenzellenzonen 6 enthalten die Gate-Elektroden 4. Die Gate-Elektroden 4 sind mit dem Gateanschluß G verbunden. Als Gate-Material wird wegen seiner prozeßtechnisch einfachen Handhabbarkeit und seiner guten Leitfähigkeit bevorzugt hochdotiertes Polysilizium verwendet. Die Gate-Elektroden 4 sind durch ein Gateoxid 8 von den angrenzenden Drainzonen 2 und Sourcezonen 3 bzw. dem Bulkbereich 5 isoliert. Als Gateoxid 8 wird bevorzugt thermisch aufgewachsenes Siliziumdioxid verwendet.

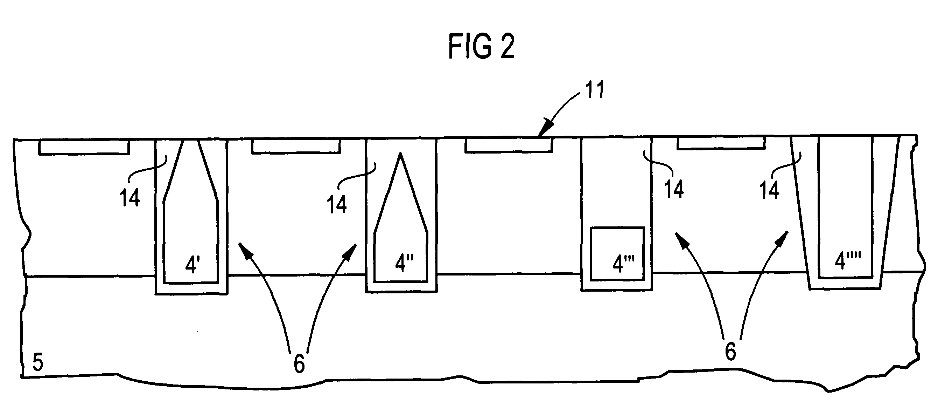

Die Gate-Elektroden 4 können verschiedenartig ausgebildet sein. In Figur 2 sind drei bevorzugte Ausführungsformen der Gate-Elektroden 4 gezeigt. Gleiche Elemente sind entsprechend Figur 1 mit gleichen Bezugszeichen versehen:
- Die Gate-Elektroden 4 weisen eine flaschenähnliche Form 4', 4'' auf, wobei sich der Flaschenbauch am unteren Ende der Zwischenzellenzonen 6 befindet und der Flaschenhals sich zur Scheibenvorderseite 11 des Halbleiterkörpers 1 hin verjüngt.
- Die Gate-Elektroden 4 weisen einen rechteckigen Querschnitt 4''' auf und befinden sich im wesentlichen im unteren Bereich der Zwischenzellenzonen 6.
- Die Gate-Elektroden 4 weisen vertikal einen rechteckigen Querschnitt 4'''' auf, der sich über die gesamte Tiefe der Zwischenzellenzonen erstreckt. Das Gateoxid 8 wird dabei zur Oberfläche der Scheibenvorderseite 11 hin dicker.

Die n⁺-dotierten Drain-/Sourcezonen 2', 3' weisen entsprechend Figur 1 eingebettete n⁺-dotierte Bereiche 2', 3' auf. Diese n⁺-dotierten Zonen 2', 3' bilden die Kontaktregionen für die Drain-/Sourcezonen 2, 3. Die Kontaktregionen 2', 3' sollten eine hohe Dotierungskonzentration aufweisen, um einen guten ohmschen Kontakt zwischen Halbleiter und Metallisierung zu gewährleisten. Üblicherweise werden die Kontaktregionen 2', 3' durch Ionenimplantation in den Halbleiter eingebracht. Dadurch läßt sich die Dotierungskonzentration über die eingebrachte Dosis exakt bestimmen. Vorteilhaft für die Spannungsfestigkeit der MOSFETs ist es, wenn die Kontaktregionen 2', 3' nicht bis zum Gateoxid 8 in den Zwischenzellenzonen 6 reichen.

Die n⁺-dotierten Drain-/Sourcezonen 2', 3' sind über übliche Metallisierungen elektrisch kontaktiert. Die Gesamtheit der Drainkontakte 9 und die Gesamtheit der Sourcekontakte 10 sind jeweils kurzgeschlossen. Die Drainmetallisierung 9 ist von der Sourcemetallisierung 10 beispielsweise durch ein Zwischenoxid 13 isoliert. Die Drainmetallisierung 9 und die Sourcemetallisierung 10 bilden den Drainanschluß D bzw. den Sourceanschluß S. Die Anordnung der Drainkontakte 9 und der Sourcekontakte 10 kann entweder zweilagig übereinander oder einlagig nebeneinander in Streifenform erfolgen. Vorteilhafterweise umschließen die die Gate-Elektroden 4 enthaltenden Zwischenzellenzonen 6 die Drain- und Sourcezonen 2, 3. Insbesondere wirkt die äußere Gate-Elektrode, wenn sie zum Beispiel auf das Potential OV gelegt wird, dann als Guardring.

Unmittelbar unterhalb der Zwischenzellenzonen 6 können hochdotierte Bereiche, vorzugsweise desselben Leitungstyps wie im Bulkbereich 5, eingebracht sein. Im vorliegenden Beispiel sind unterhalb der Zwischenzellenzonen 6 p⁺-dotierte Bereiche eingebracht. Diese Bereiche werden im folgenden als Kanalzone 7 bezeichnet. Der zugrundeliegende Technologieschritt wird allgemein als Kanaldotierung bezeichnet. Bei der Kanaldotierung kann durch Einbringen einer exakt bestimmbaren Dotierungskonzentration die Einsatzspannung für den Kanal eines MOS-Transistors festgelegt werden. Üblicherweise wird auch hierfür Ionenimplantation angewendet. Bei der Kanaldotierung kann vorteilhafterweise der geätzte Graben 6, bei dem die Gate-Elektrode 4 und das Gateoxid 8 noch nicht eingebracht wurden, als Implantationsmaske verwendet werden. Die Kanalzonen 7 können auch durch eine großflächige, dünne p⁺-dotierte Epitaxieschicht zwischen Bulkbereich 5 und Drain-/Sourceezonen 2, 3 ersetzt werden.

Die in Figur 1 gezeigten MOSFETs werden als selbstsperrende n-Kanal-MOSFETs bezeichnet. Hier sind die Leitungstypen von Drain-/Sourcezone 2, 3 und der Kanalzone 7 unterschiedlich. Selbstverständlich lassen sich die erfindungsgemäßen MOSFETs auch als selbstleitende Transistoren realisieren. Hierzu muß der Leitungstyp der Kanalzone 7 gleich dem Leitungstyp von Drain-/Sourcezonen 2, 3 sein. Bei diesen selbstleitenden MOSFETs muß die aber Kanalzone 7 die Drain- und Sourcezonen 2, 3 berühren. Sind die Drain-/Sourcezonen 2, 3 p-dotiert und der Bulkbereich n-dotiert, dann lassen sich entsprechend auch p-Kanal-MOSFETs realisieren.

Nachfolgend wird die Funktionsweise einer derartigen erfindungsgemäßen Anordnung erläutert.

Wird im Ausführungsbeispiel von Figur 1 eine positive Spannung an die Gate-Elektrode 4 gelegt, dann bildet sich in der p⁺-dotierten Kanalzone 7 unterhalb der Gate-Elektrode 4 eine Inversionsschicht bzw. ein n-Kanal aus. Dieser Kanal ist je nach angelegter Gatespannung mehr oder weniger n-leitend. Außerdem werden die n-dotierten Bereiche der Source- und Drainzone 2, 3, die unmittelbar an die Zwischenzellenzonen 6 angrenzen, durch die angelegte Gatespannung noch stärker n-leitend, wobei diese n-Leitung mit zunehmender Tiefe durch das Design der Gate-Elektrode zunimmt. Wird der Drainanschluß auf positives Potential gelegt, dann fließt ein Strom von der Sourcezone über den Kanal unter der Gate-Elektrode zur Drainzone. Das gezeigte Beispiel entspricht also einer vertikalen Realisierung der Gate-Elektrode 4 des in DE 27 06 623 gezeigten MOSFET mit lateraler Gate-Elektrode.

Die Breite der Zwischenzellenzonen 6 ist dabei ein Maß für die Kanalweite der MOSFETs. Die Dicke der Drainzone 2 entspricht der Driftstrecke der Leistungs-MOSFETs und ist damit ein Maß für die Spannungsfestigkeit. Wesentlich für einen Leistungs-MOSFET der genannten Art ist dabei der Abstand der n⁺-dotierten Drainbereiche 2' von der Gate-Elektrode 4. Dieser Abstand bestimmt die Durchbruchspannung eines gattungsgemäßen MOSFET. Vorteilhafterweise hat die Gate-Elektrode 4 eine flaschenähnliche Form entsprechend Figur 2. Die Dicke des Gateoxides vergrößert sich hier zur Oberfläche des Halbleiterkörpers hin.

Damit erfüllt die erfindungsgemäße Anordnung die Anforderung eines niederohmigen Einschaltwiderstandes R_{ON} bei gleichzeitig hoher Spannungsfestigkeit. Durch die Realisierung der Gate-Elektrode 4 in vertikalen Gräben läßt sich zusätzlich Chipfläche sparen.

Die erfindungsgemäßen Strukturen können sowohl bei lateral als auch bei vertikal aufgebauten Halbleiterstrukturen verwendet werden.

Nachfolgend wird ein bevorzugtes Herstellungsverfahren für eine Anordnung gemäß Figur 1 beschrieben:

Auf der Scheibenvorderseite einer p⁻-dotierte Siliziumscheibe wird eine n-dotierte Epitaxieschicht aufgebracht. Die Scheibenvorderseite 11 wird strukturiert und die n⁺-dotierten Kontaktregionen 2', 3' werden durch Ionenimplantation in die Drain-/Sourcezonen 2, 3 eingebracht. Alternativ wäre auch denkbar, die Kontaktregionen 2', 3' durch Diffusion zu erzeugen. Die Scheibenvorderseite 11 wird erneut strukturiert und die Zwischenzellenzonen 6 werden anisotrop geätzt. Unter Verwendung der vorhandenen Ätzmaske werden die p⁺-dotierten Kanalzonen 7 unterhalb der Zwischenzellenzonen 6 durch Ionenimplantation eingebracht. Anschließend wird eine dünne thermische Siliziumdioxidschicht als Gateoxid 8 an die Grabenwände aufgebracht. Die Zwischenzellenzonen 6 werden anschließend mit dotiertem Polysilizium als Material für die Gate-Elektroden 4 aufgefüllt. Überschüssiges Polysilizium wird aus den Zwischenzellenzonen 6 herausgeätzt und die Zwischenzellenzonen 6 werden mit Siliziumdioxid aufgefüllt. Der Substratanschluß an der Scheibenrückseite 12 wird großflächig metallisiert. Die Scheibenvorderseite 11 wird strukturiert und die Drainanschlüsse D, Sourceanschlüsse S und Gateanschlüsse G werden an den entsprechenden Kontakten metallisiert und voneinander durch ein Zwischenoxid 13 isoliert.

Zusammenfassend ist zu bemerken, daß durch die vorliegende Erfindung laterale MOSFETs mit niedrigem Durchlaßwiderstand R_{ON} bei gleichzeitig hoher Durchbruchspannung realisierbar sind. Wesentlich ist die Ausbildung von vertikalen Gräben mit nach oben steigender Gateoxiddicke, die die Gate-Elektroden enthalten. Die vorliegende Erfindung ist dabei sowohl bei p-Kanal-MOSFETs wie auch bei n-Kanal-MOSFETs anwendbar.

### Bezugszeichenliste

- 1: Halbleiterkörper
- 2: Drainzone
- 2': Kontaktregion in der Drainzone
- 3: Sourcezone
- 3': Kontaktregion in der Sourcezone
- 4: Gate-Elektroden
- 4',4'',4''',4'''': Ausgestaltungen der Gate-Elektroden
- 5: Bulkbereich
- 6: Zwischenzellenzone, Graben
- 7: Kanalzone
- 8: Gateoxid
- 9: Drainmetallisierung
- 10: Sourcemetallisierung
- 11: Scheibenvorderseite
- 12: Scheibenrückseite
- 13: Zwischenoxid
- G: Gateanschluß
- D: Drainanschluß
- S: Sourceanschluß

## Patentansprüche

1. Durch Feldeffekt steuerbares Halbleiterbauelement bestehend aus einem Halbleiterkörper (1) mit
- mindestens einer Drainzone (2) vom ersten Leitungstyp,
- mindestens einer Sourcezone (3) vom ersten Leitungstyp,
- mindestens einer Gate-Elektrode (4), wobei diese gegenüber dem gesamten Halbleiterkörper (1) durch ein Gateoxid (8) isoliert ist,
**dadurch gekennzeichnet,**
daß Zwischenzellenzonen (6) vorgesehen sind, die folgende Merkmale aufweisen:
- die Zwischenzellenzonen (6) beabstanden jeweils benachbarte Drainzonen (2) und Sourcezonen (3),
- die Zwischenzellenzonen (6) enthalten die Gate-Elektroden (4) und das Gateoxid (8),
- die Zwischenzellenzonen (6) haben die Form von vertikalen Gräben, die sich von der Oberfläche der Scheibenvorderseite (11) vertikal über die Drain- und Sourcezonen (2, 3,) hinaus in den Bulkbereich (5) des Halbleiterkörpers (1) erstrecken.

2. Durch Feldeffekt steuerbares Halbleiterbauelement nach Anspruch 1,
**dadurch gekennzeichnet,**
daß die Gate-Elektroden (4) vertikal eine flaschenähnliche Form (4', 4'') aufweisen, wobei sich der Flaschenbauch am unteren Ende der Zwischenzellenzonen (6) befindet und der Flaschenhals sich zur Oberfläche der Scheibenvorderseite (11) des Halbleiterkörpers (1) hin verjüngt und das Gateoxid (8) zunimmt.

3. Durch Feldeffekt steuerbares Halbleiterbauelement nach Anspruch 1,
**dadurch gekennzeichnet,**
daß die Gate-Elektroden (4) vertikal einen rechteckigen Querschnitt (4''') aufweisen und sich im wesentlichen im unteren Bereich der Zwischenzellenzonen (6) befinden.

4. Durch Feldeffekt steuerbares Halbleiterbauelement nach Anspruch 1,
**dadurch gekennzeichnet,**
daß die Gate-Elektroden (4'''') vertikal einen rechteckigen Querschnitt aufweisen und sich über die gesamte Tiefe der Zwischenzellenzonen erstrecken, wobei das Gateoxid (8) zur Oberfläche der Scheibenvorderseite (11) hin dicker wird.

5. Durch Feldeffekt steuerbares Halbleiterbauelement nach einem der Ansprüche 1 bis 4,
**dadurch gekennzeichnet,**
daß das Material der Gate-Elektroden (4) hochdotiertes Polysilizium ist.

6. Durch Feldeffekt steuerbares Halbleiterbauelement nach einem der Ansprüche 1 bis 5,
**dadurch gekennzeichnet,**
daß unmittelbar unter den Zwischenzellenzonen (6) Kanalzonen (7) vom ersten oder vom zweiten Leitungstyp eingebracht sind.

7. Durch Feldeffekt steuerbares Halbleiterbauelement nach Anspruch 6,
**dadurch gekennzeichnet,**
daß die Kanalzonen (7) implantiert sind.

8. Durch Feldeffekt steuerbares Halbleiterbauelement nach einem der Ansprüche 1 bis 7,
**dadurch gekennzeichnet,**
daß in den Drain- und Sourcezonen (2, 3) hochdotierte Kontaktregionen (2', 3') vom selben Leitungstyp wie in den Drain- bzw. Sourcezonen (2, 3) eingebettet sind.

9. Durch Feldeffekt steuerbares Halbleiterbauelement nach Anspruch 8,
**dadurch gekennzeichnet,**
daß die Kontaktregionen (2' 3') implantiert sind und vom Gateoxid (8) beabstandet sind.

10. Verfahren zur Herstellung eines durch Feldeffekt steuerbaren Halbleiterbauelementes nach einem der Ansprüche 1 - 9,
**dadurch gekennzeichnet,**
daß nachfolgende Verfahrensschritte ausgeführt werden:
- auf dem Bulkbereich (5) eines Halbleiterkörpers (1) wird die Drain/Sourcezone (2, 3) epitaktisch abgeschieden,
- die Scheibenvorderseite (11) wird strukturiert und die hochdotierten Bereiche (2', 3') der Drain/Sourcezonen (2, 3) werden durch Ionenimplantation eingebracht,
- die Scheibenvorderseite (11) wird erneut strukturiert und die Zwischenzellenzonen (6) werden anisotrop geätzt,
- unter Verwendung der Ätzmaske werden die Kanalzonen (7) unterhalb der Zwischenzellenzonen (6) durch Ionenimplantation eingebracht,
- unter Verwendung der Ätzmaske wird eine dünne Siliziumdioxidschicht als Gateoxid (8) auf die Wände der Zwischenzellenzonen (6) thermisch aufgebracht, die Zwischenzellenzonen (6) werden mit Polysilizium als Gatematerial aufgefüllt, überschüssiges Polysilizium wird aus den Zwischenzellenzonen (6) herausgeätzt und die Zwischenzellenzonen (6) werden mit Siliziumdioxid als Gateoxid (8) aufgefüllt,
- der Sourceanschluß (S), der Drainanschluß (D) und der Gateanschluß (G) werden an der Scheibenvorderseite (11) an den entsprechenden Kontakten metallisiert und voneinander durch ein Zwischenoxid (13) isoliert.
